# FASCICULE DE BREVET EUROPEEN

(11) **EP 0 494 001 B1**
(45) Date de publication et mention de la délivrance du brevet: **05.06.1996**
(21) Numéro de dépôt: 91403456.6
(22) Date de dépôt: 19.12.1991
(51) Int. Cl.: H01L 23/44, G01J 5/06, F25D 19/00

(54) **Doigt de refroidissement d'un circuit semi-conducteur et dispositif cryogénique pourvu d'un tel doigt**
Kühlfinger für Halbleiterschaltung und kryogenische Anordnung mit solchem Finger
Cold finger for semiconductor circuit and cryogenic device having such finger

(30) Priorité: 04.01.1991 FR 9100065
(43) Date de publication de la demande: 08.07.1992
(73) Titulaire: SAT (Société Anonyme de Télécommunications), F-75116 Paris (FR)
(72) Inventeur: Daugy, Patrick, F-75013 Paris (FR); Langlet, Jean-Pierre, F-91450 Etoilles (FR); Loiseau, Joseph, F-94410 Saint Maurice (FR)
(74) Mandataire: Bloch, Gérard

(56) Documents cités:
- EP-A- 0 364 347
- US-A- 4 810 888

## Description

La présente invention a tout d'abord pour objet un doigt creux de refroidissement d'un circuit semi-conducteur dont la paroi délimite un volume intérieur destiné à recevoir un fluide cryogénique introduit par la base du doigt, et dont l'extrémité libre présente une face extérieure en contact thermique avec le circuit à refroidir.

Un tel doigt est utilisé notamment dans les cryostats destinés à maintenir un circuit semi-conducteur détecteur de rayonnement à une température de fonctionnement optimale, de valeur relativement basse. En particulier, un tel cryostat est utilisé pour les détecteurs infra-rouges qui sont utilisés pour la vision nocturne ou pour le guidage des missiles.

EP-A-364 347 enseigne un cryostat dont le doigt, de forme générale cylindrique, est disposé dans une enceinte transparente au rayonnement à détecter, au moins dans la zone en regard du détecteur. Le vide est fait à l'intérieur de l'enceinte, pour isoler thermiquement le doigt et le milieu extérieur. Le détecteur, comprenant généralement une mosaïque de détecteurs élémentaires, convertit le rayonnement qu'il reçoit en signaux électriques amenés à l'extérieur de l'enceinte par des connexions traversant sa paroi de façon hermétique, en vue de leur exploitation.

Le fluide cryogénique qui sert à refroidir le volume intérieur du doigt peut être un gaz liquéfié comme de l'azote liquide simplement versé dans le doigt froid. Cependant ce mode de refroidissement est limité au laboratoire, et pour les systèmes opérationnels civils ou militaires, on préfère utiliser un fluide produit par une machine cryogénique, comme un refroidisseur à détente Joule-Thomson ou un refroidisseur mécanique à cycle fermé.

Pour isoler thermiquement l'extrémité libre du doigt, l'épaisseur de la paroi du doigt est maintenue aussi faible que possible.

Dans les conditions d'environnement militaires, les cryostats peuvent être soumis à de sévères contraintes mécaniques. Les niveaux de vibrations auxquels doivent résister les systèmes peuvent être amplifiés par des phénomènes de résonance dus au couplages et aux structures mécaniques des différentes pièces constituants ces systèmes.

La structure même d'un doigt de refroidissement de cryostat, qui est celle d'une tige vibrante creuse, le rend particulièrement sensible aux vibrations. Lors des résonances, le détecteur se déplace de manière significative devant le fond ambiant, induisant un signal parasite à la fréquence de résonance qui diminue la sensibilité de ce détecteur. De plus, il peut se produire des déformations irréversibles pouvant aller jusqu'à la rupture du doigt froid.

Pour éviter ces inconvénients, on peut envisager de déplacer la fréquence de résonance mécanique pour qu'elle se trouve au delà du domaine de fréquence d'excitation considéré, qui s'étend en général de 10 à 2000 Hz. Or, la fréquence de résonance d'une tige creuse augmente avec l'épaisseur de la paroi et diminue avec la longueur de la tige. Augmenter la fréquence de résonance revient donc à augmenter l'épaisseur de la paroi et à diminuer la longueur du doigt. Il en résulte que l'augmentation de la fréquence ne peut se faire qu'au détriment de l'isolation thermique et de la durée de mise en froid, qui représentent des caractéristiques fondamentales du doigt froid.

La présente invention vise à pallier cet inconvénient en procurant un doigt de refroidissement dont la structure permet de parvenir à un compromis entre le bon comportement thermique et le bon comportement mécanique plus favorable que dans les doigts de structure connue.

A cet effet, elle a pour objet un doigt de refroidissement du type défini ci-dessus, caractérisé par le fait que, au moins dans une première partie du doigt adjacente à la base et au moins dans des zones de renforcement, l'épaisseur de la paroi augmente progressivement en se rapprochant de la base.

Dans le doigt de l'invention, l'épaississement de la paroi vers la base du doigt procure une augmentation sensible de la fréquence de résonance. Toutefois, du fait que dans la partie proche de l'extrémité libre destinée au refroidissement du détecteur, l'épaisseur de la paroi reste relativement mince, l'isolation thermique reste satisfaisante.

Avantageusement, le doigt comprend une deuxième partie adjacente à ladite face extérieure dont l'épaisseur de paroi est constante et assure un isolement thermique.

Dans une forme de réalisation particulière, ladite deuxième partie présente une section transversale qui diminue progressivement en s'éloignant de ladite face extérieure.

Dans ce cas, on obtient, en particulier dans les cas où le fluide cryogénique est produit par un refroidisseur à détente Joule-Thomson ou par un refroidisseur mécanique à cycle fermé, une mise en froid rapide et uniforme du circuit à refroidir, du fait notamment que la forme du volume intérieur du doigt au voisinage de son extrémité libre procure un écoulement laminaire, sans turbulences, du fluide cryogénique.

La présente invention a également pour objet un dispositif cryogénique caractérisé par le fait qu'il comprend un doigt de refroidissement du type défini ci-dessus.

La présente invention sera mieux comprise à la lecture de la description suivante de plusieurs formes de réalisation préférées du doigt de l'invention, faite en se référant aux dessins annexés, sur lesquels :
- la figure 1 représente une vue en coupe simplifiée d'une première forme de réalisation du doigt de refroidissement de l'invention,
- la figure 2 représente une vue analogue à celle de la fig. 1, d'une deuxième forme de réalisation du doigt de refroidissement de l'invention,
- la figure 3 représente une vue en coupe transversale d'une variante de réalisation du doigt de l'invention, au voisinage de sa base.

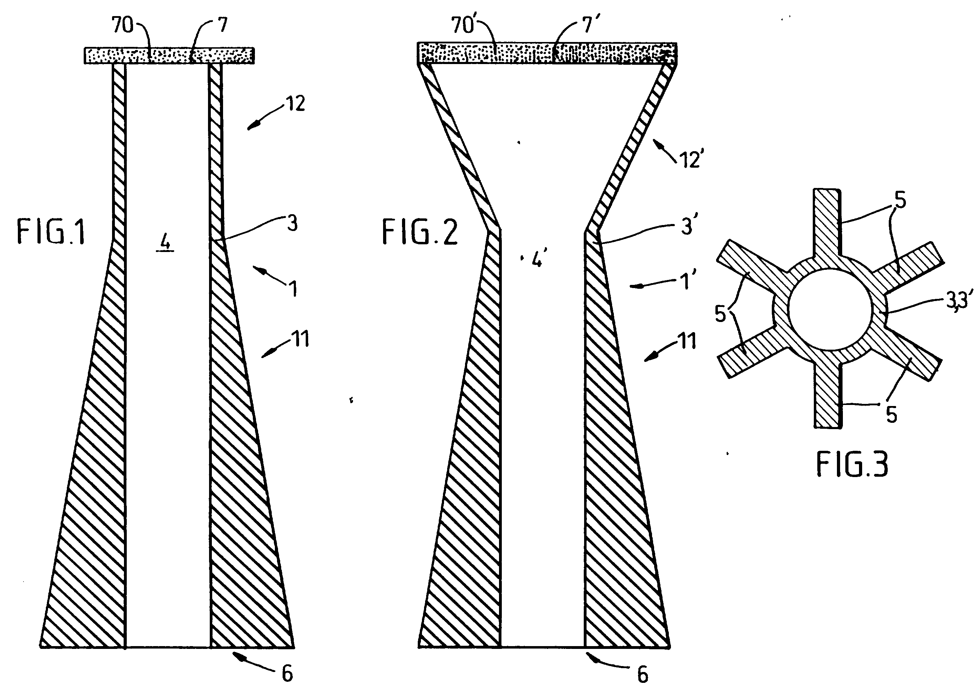

En se référant à la figure 1, un doigt de refroidissement 1, ici à symétrie de révolution autour de son axe, comprend une paroi 3 qui délimite un volume intérieur 4, ici cylindrique, destiné à recevoir un fluide cryogénique non représenté, et introduit par la base 6 du doigt 1.

L'extrémité libre du doigt 1 présente une face 7 dont l'extérieur est en contact thermique, par l'intermédiaire ici d'un plateau porte-circuit 70, avec un circuit à refroidir non représenté, par exemple un détecteur infra-rouge.

Dans une partie 11 du doigt 1, adjacente à sa base 6, l'épaisseur de la paroi 3 augmente progressivement en se rapprochant de la base 6. Ici, l'épaisseur varie linéairement avec le rapprochement et la partie 11 se présente donc, extérieurement comme un tronc de cône. Elle pourrait cependant se présenter comme un tronc de pyramide, de même que la loi de variation de l'épaisseur pourrait ne pas être linéaire avec le rapprochement.

Dans une partie 12 adjacente à la face 7 et donc à l'extrémité du doigt, la paroi 3 est d'épaisseur constante et aussi faible que possible pour assurer un bon isolement thermique.

Ici, l'épaisseur de la paroi 3 dans la partie 12 est égale à l'épaisseur de la paroi 3 dans la zone de la partie 11 où celle-ci se raccorde à la partie 12. Toujours dans l'exemple décrit, la longueur de la partie 11 est supérieure à celle de la partie 12, et égale approximativement à 2,5 fois cette longueur.

Dans la forme de réalisation de la figure 2, la partie 11 du doigt 1′ est identique à celle de la partie 11 du doigt 1 de la figure 1. Toutefois, le volume intérieur 4′ se termine ici, vers l'extrémité libre du doigt par une partie conique, du fait que dans la partie 12′ où l'épaisseur de la paroi 3′ est constante, la section transversale du doigt diminue progressivement en s'éloignant de la face 7 et du porte-détecteur 70′.

Comme cela a été indiqué, cette partie conique du volume 4′ facilite l'écoulement du fluide cryogénique au voisinage de la face 7.

Sur les figures 1 et 2, les parois 3 et 3′ sont massives, en ce sens que c'est la totalité de ces parois qui subit une augmentation d'épaisseur jusqu'à la base 6 du doigt fixée sur un bâti.

La figure 3 montre une variante de réalisation dans laquelle c'est seulement dans des zones de renforcement 5 que la paroi 3, ou 3′, s'épaissit. Les zones de renforcement 5 agissent comme raidisseurs, et à la manière de contreforts dans un ouvrage d'architecture. Dans ce cas, l'isolation thermique est encore meilleure.

Le matériau des parois 3 et 3′ est évidemment un matériau résistant et de faible conductivité thermique, comme l'acier inoxydable ou le matériau connu sous le nom de Kovar.

## Revendications

1. Doigt creux (1; 1) de refroidissement d'un circuit semi-conducteur dont la paroi (3;3') délimite un volume intérieur (4;4') destiné à recevoir un fluide cryogénique introduit par la base (6) du doigt, et dont l'extrémité libre présente une face extérieure (7; 7') en contact thermique avec le circuit à refroidir, caractérisé par le fait qu'une première partie (11) du doigt (1) adjacente à la base (6) présente une épaisseur de paroi (3;3') augmentant progressivement, au moins dans des zones de renforcement (5), en se rapprochant de la base (6).

2. Doigt selon la revendication 1, comprenant une deuxième partie (12; 12′) adjacente à ladite face extérieure (7; 7′) dont l'épaisseur de paroi est constante et assure un isolement thermique.

3. Doigt selon l'une des revendications 1 ou 2, dans lequel ladite deuxième partie (12′) présente une section transversale qui diminue progressivement en s'éloignant de ladite face extérieure (7′).

4. Dispositif cryogénique caractérisé par le fait qu'il comprend un doigt selon l'une des revendications 1 à 3.

## Patentansprüche

1. Hohler Finger (1 ; 1') um eine Halbleiterschaltung zur kühlen, dessen Wand (3 ; 3') einen zur Aufnahme eines durch die Basis (6) des Fingers hindurch eingeführten kryogenischen Fluids Innenraum (4 ; 4') begrenzt und dessen freies Ende eine in thermischem Kontakt mit der zu kühlenden Schaltung kommende AuBenfläche (7 ; 7') aufweist, dadurch gekennzeichnet, daB ein erster Abschnitt (11) des Fingers (1), zumindest in Verstärkungszonen (5), nahe der Basis (6) eine in Annäherung an diese Basis progressiv zunehmende Stärke der Wand (3 ; 3') aufweist.

2. Finger nach Anspruch 1 mit einem zweiten Abschnitt (12 ; 12') nahe der AuBenfläche (7 ; 7'), dessen Wandstärke konstant ist und eine thermische Isolation sichert.

3. Finger nach einem der Ansprüche 1 order 2, bei dem der zweite Abschnitt (12') einen mit der Entfernung von der AuBenfläche (7') progressiv abnehmenden Querschnitt aufweist.

4. Kryogenische Anordnung, dadurch gekennzeichnet, daB sie einen Finger nach einem der Ansprüche 1 bis 3 aufweist.

## Claims

1. A hollow finger (1 ; 1') for cooling a semiconductor circuit, the wall (3 ; 3') of which delimits an internal volume (4 ; 4') intended to receive a cryogenic fluid introduced through the base (6) of the finger, and the free end of which has an external face (7 ; 7') in thermal contact with the circuit to be cooled, characterised in that a first part (11) of the finger (1) adjacent to the base (6) has a wall thickness (3 ; 3') which progressively increases, at least in zones of reinforcement (5), as it approaches the base (6).

2. A finger according to claim 1, comprising a second part (12 ; 12') adjacent to the said external face (7 ; 7'), the wall thickness of which is constant and ensures a thermal insulation.

3. A finger according to either one of claims 1 or 2, wherein the said second part (12') has a transversal cross-section which progressively decreases as it recedes from the said external face (7').

4. A cryogenic device characterised in that is comprises a finger according to any one of claims 1 to 3.
